# EUROPEAN PATENT APPLICATION

(11) **EP 4 546 399 A1**
(43) Date of publication of application: **30.04.2025**
(21) Application number: 23206097.0
(22) Date of filing: 26.10.2023
(51) Int. Cl.: H01L 21/48, H01L 23/31, H01L 23/495

(54) **MOLDED POWER PACKAGE WITH VERTICAL INTERCONNECT**

(71) Applicant: Infineon Technologies Austria AG, 9500 Villach (AT)
(72) Inventor: LEE, Chee Hong, 76450 Paya Rumput (MY); CHUA, Kok Yau, 75050 Melaka (MY); LEE, Chai Chee, 75000 Melaka (MY); TAN, Chee Voon, 70300 Seremban (MY); CHELLAMUTHU, Naveendran, 76100 Melaka (MY)
(74) Representative: Lambsdorff & Lange Patentanwälte Partnerschaft mbB

(57) **Abstract**

A molded power package includes a laser-activatable mold compound having a plurality of laser-activated regions which are plated with an electrically conductive material to form metal pads and/or metal traces at a first side of the laser-activatable mold compound. The package further includes a semiconductor power die embedded in the laser-activatable mold compound and having a plurality of bond pads and a bond pad interconnect electrically connecting the plurality of bond pads of the semiconductor power die to the metal pads and/or metal traces at the first side of the laser-activatable mold compound. A leadframe includes a carrier section on which the semiconductor power die is mounted and a carrier interconnect section integral with the carrier section. The carrier interconnect section electrically connects the carrier section to the metal pads and/or metal traces at the first side of the laser-activatable mold compound. An upper surface of the carrier interconnect section is at a height that is elevated relative to an upper surface of the carrier section.

## Description

### Technical Field

This disclosure relates generally to the field of semiconductor die packaging, and in particular to the field of forming a molded power package including a package interconnect.

### Background

Semiconductor device manufacturers are constantly striving to increase the performance of their products, while decreasing their cost of manufacture. A cost and device performance sensitive area in the manufacture of a semiconductor device is packaging the semiconductor die. Packaging involves encapsulating the semiconductor die and forming an interconnect from bond pads to package terminals. The packaging concept and interconnect technology should provide for high electrical and thermal performance and reliability of the semiconductor device. They should further support package scalability and die shrinkage.

### Summary

According to an embodiment of a molded power package, the molded power package comprises a laser-activatable mold compound having a plurality of laser-activated regions which are plated with an electrically conductive material to form metal pads and/or metal traces at a first side of the laser-activatable mold compound; a semiconductor power die embedded in the laser-activatable mold compound and having a plurality of bond pads; a bond pad interconnect electrically connecting the plurality of bond pads of the semiconductor power die to the metal pads and/or metal traces at the first side of the laser-activatable mold compound; and a leadframe comprising a carrier section on which the semiconductor power die is mounted and a carrier interconnect section integral with the carrier section, the carrier interconnect section electrically connecting the carrier section to the metal pads and/or metal traces at the first side of the laser-activatable mold compound. An upper surface of the carrier interconnect section is at a height that is elevated relative to an upper surface of the carrier section.

According to an embodiment of a method of manufacturing a molded package, the method comprises providing a leadframe comprising a carrier section and a carrier interconnect section integral with the carrier section, wherein an upper surface of the carrier interconnect section is at a height that is elevated relative to an upper surface of the carrier section; placing a semiconductor power die on the carrier section of a leadframe, the semiconductor power die having a plurality of bond pads facing away from the carrier section; attaching a bond pad interconnect to the plurality of bond pads of the semiconductor power die before or after placing the semiconductor power die on the carrier section; embedding the semiconductor power die and the bond pad interconnect in a laser-activatable mold compound; directing a laser at a first side of the laser-activatable mold compound to laser-activate a plurality of regions of the laser-activatable mold compound; and plating an electrically conductive material on the plurality of laser-activated regions of the laser-activatable mold compound to form metal pads and/or metal traces at the first side of the laser-activatable mold compound, wherein the bond pad interconnect electrically connects the plurality of bond pads of the semiconductor power die to the metal pads and/or metal traces at the first side of the laser-activatable mold compound, and the carrier interconnect section electrically connects the carrier section of the leadframe to the metal pads and/or metal traces at the first side of the laser-activatable mold compound.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is a schematic cross-sectional view of an example of a molded power package including a leadframe and a laser-activatable mold compound for die embedding.
Figures 2A to 2F are schematic cross-sectional views illustrating stages of manufacturing the molded power package of Figure 1.
Figure 3 is a perspective view of an example of a leadframe for fabricating an example of a molded power package including multiple dies, for example.
Figures 4A to 4D are perspective views illustrating stages of manufacturing a molded power package including, e.g., multiple dies.
Figure 5 is a perspective view of an example of a molded power package including, e.g., multiple dies.
Figure 6 is a semi-transparent perspective view of the power package of Figure 5.
Figure 7 is a semi-transparent perspective view of an example of a power package including a gate driver chip embedded in the laser-activatable mold compound.
Figure 8A is a perspective view on a top side of the power package of Figure 7.
Figure 8B is a perspective view on a bottom side of the power package of Figure 7.

### Detailed description

The words "over" or "on" or "beneath" with regard to a part, element or material layer formed or located or disposed or arranged or placed "over" or "on" or "beneath" a surface may be used herein to mean that the part, element or material layer be located (e.g. placed, formed, arranged, disposed, placed, etc.) "directly on" or "directly under", e.g. in direct contact with, the implied surface. The word "over" or "on" or "beneath" used with regard to a part, element or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

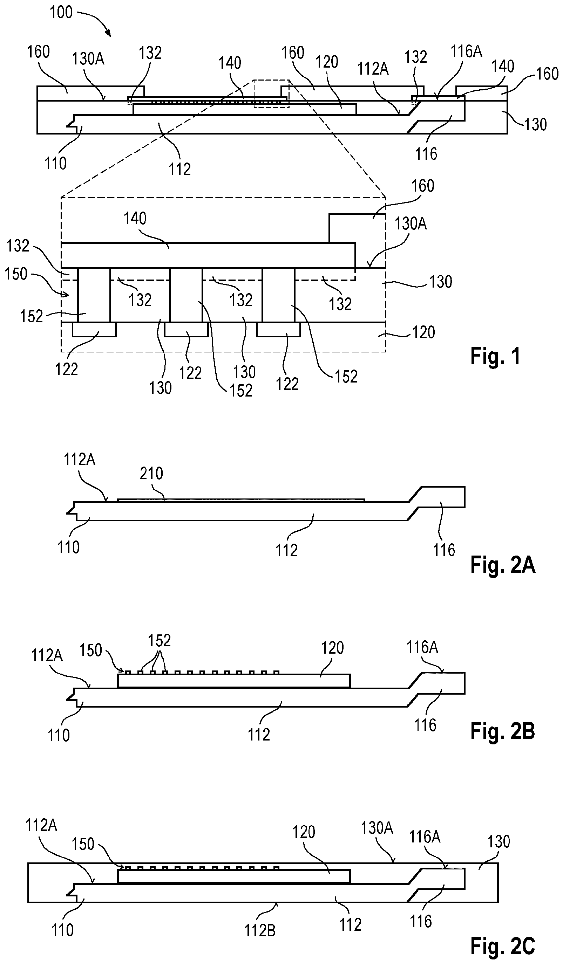

Figure 1 illustrates a cross-sectional view of an example of a molded power package 100. The molded power package 100 includes a leadframe 110 and a semiconductor power die (chip) 120 mounted on the leadframe 110. Further, the molded power package 100 includes a laser-activatable mold compound 130 in which the semiconductor power die 120 is embedded.

The semiconductor power die 120 includes a plurality of bond pads 122. The bond pads 122 are electrically connected by a bond pad interconnect 150 to metal pads and/or metal traces 140 disposed at an upper side 130A of the laser-activatable mold compound 130.

For forming the metal pads and/or metal traces 140, the laser-activatable mold compound has a plurality of laser-activated regions 132. The laser-activated regions 132 of the laser-activatable mold compound 130 are plated with an electrically conductive material, which forms the metal pads and/or metal traces 140.

Any type of bond pad interconnect 150 may be used. For example, the bond pad interconnect 150 may include a plurality of vertical interconnect structures 152. Each of the interconnect structures 152 may be attached at a first end to a bond pad 122 of the semiconductor power die 120 and at a second end opposite the first end to the metal pads and/or metal traces 140 at the upper side 130A of the laser-activatable mold compound 130.

Any type of interconnect structures 152 may be used in the bond pad interconnect 150. For example, the interconnect structures 152 may be formed by wire stud bumps or metal pillars or vertical bond wires. Other types of interconnect structures include, for example, solder bumps.

A wire stud bump may be made of a metal such as copper, gold, aluminium, nickel, etc., or a metal alloy based on any such metal. Metal pillars may, e.g., be made of the same metals. In yet another example, the interconnect structures 152 may include vertical bond wires attached at a first end to the bond pads 122 and attached at a second end opposite the first end to the metal pads and/or metal traces 140. The second end may be formed by cutting the bond wire after the first end is bonded to the corresponding bond pad 122.

The leadframe 110 includes a carrier section 112 and a carrier interconnect section 116. The semiconductor power die 120 is mounted on the carrier section 112. The carrier interconnect section 116 is integral with the carrier section 112 and connects the carrier section 112 to metal pads and/or metal traces 140 at the upper side 130A of the laser-activatable mold compound 130.

As shown in Figure 1, an upper surface 116A of the carrier interconnect section 116 is at a height that is elevated relative to an upper surface 112A of the carrier section 112.

That way, the carrier interconnect section 116 protruding from the carrier section 112 of the leadframe 110 forms a connection to the metal pad and/or metal traces 140 of the package 100. As the metal pads and/or metal traces 140 may be used for electrical redistribution and for package input/output (I/O), e.g., as external package terminals, the package 100 combines a bond pad interconnect 150 formed by a plurality of interconnect structures 152 with a protruded leadframe interconnect formed by the carrier interconnect section 116 in a molded power package 100 using laser-activatable mold compound 130.

The leadframe 110 may form a heat sink of the molded power package 100. As the leadframe 110 may be at a load terminal (e.g. source) potential in operation, it can act to prevent strong dynamic R_{DS(on)} (on-resistance) and current collapse during operation as experienced in packages in which the die carrier is electrically floating.

As will be described in more detail further below, the above concept may simplify the process of manufacturing a molded power package 100 having a leadframe 110, a power die 120 and a laser-activatable mold compound 130 used for fabricating the metal pads and/or metal traces 140 for I/O connectivity of the power package 100. In particular, no separate parts and no bonding material (e.g., solder paste, electrically conductive glue material) are needed to connect the leadframe 110 at the bottom of the package 100 to the top side of the package 100. Further, due to the integral design of the leadframe 110 including the carrier section 112 and the carrier interconnect section 116, the power package 100 may exhibit advanced reliability and robustness.

In some examples, the carrier interconnect section 116 may be an edge part of the leadframe 110. The elevated height of the carrier interconnect section 116 relative to the upper surface 112A of the carrier section 112 may, e.g., be provided by a bending or stamping process. For example, an edge part of the leadframe 110 is stamped-up or bent-up during leadframe fabrication to provide the elevated carrier interconnect section 116 of the leadframe 110.

As shown in Figure 1, the second ends of the interconnect structures 152 (e.g., wire stud bumps or metal pillars or vertical bond wires, etc.) may be at the same height as the upper surface 116A of the carrier interconnect section 116. Further, the second ends of the interconnect structures 152 and the upper surface 116A of the carrier interconnect section 116 may be at the same height as the upper side 130A of the laser-activatable mold compound 130, for example. That way, the metal pads and/or metal traces 140 may be generated simultaneously on the laser-activated regions 132 of the laser activatable mold compound 130, the second ends the vertical interconnect structures 152 and the upper surface 116A of the carrier interconnect section 116.

An isolation layer 160 may be applied over the metal pads and/or metal traces 140 and (non-activated regions of) the upper side 130A of the laser-activatable mold compound 130. As shown in Figure 1, the isolation layer 160 may be structured to expose portions (e.g., pad portions) of the metal pads and/or metal traces 140. The isolation layer 160 may, e.g., be a solder mask layer and/or comprise a solder stop material applied as a layer.

Figures 2A to 2F are cross-sectional views illustrating stages of manufacturing the molded power package 100. Referring to Figure 2A, the leadframe 110 including the carrier section 112 and the carrier interconnect section 116 protruding in vertical direction from the carrier section 112 is provided.

As further shown in Figure 2A, a bonding material 210 may be disposed on the upper surface 112A of the carrier section 112. The bonding material 210 may, e.g., include solder paste or a glue material. The bonding material 210 may be applied to the upper surface 112A of the leadframe 110 by a printing process, e.g., by screen printing. In the following Figures 2B to 2F, for ease of illustration, the bonding material 210 is not shown.

Referring to Figure 2B, the semiconductor power die 120 is placed on the carrier section 112 of the leadframe 110. As mentioned before, the semiconductor power die 120 has a plurality of bond pads 122 (see Figure 1) facing away from the carrier section 112.

The semiconductor power die 120 comprises or is of a semiconductor material. Examples of such semiconductor materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AlInN), indium gallium nitride (InGaN), aluminum gallium indium nitride (AlGaInN) or indium gallium arsenide phosphide (InGaAsP), etc.

The semiconductor power die 120 may, e.g., be a horizontal semiconductor device having bond pads 122 (only) at its upper surface. As an example, the semiconductor power die 120 may be a GaN power transistor, in particular a GaN HEMT (high electron mobility transistor). For example, as will be described in more detail further below, the semiconductor power die 120 may have a source (S) bond pad 122, a drain (D) bond pad 122 and a gate (G) bond pad 122 at its upper surface.

Still referring to Figure 2B, the bond pad interconnect 150 is attached to the plurality of bond pads 122 of the semiconductor power die 120. The bond pad interconnect 150 may be attached to the bond pads 122 before or after placing the semiconductor power die 120 on the carrier section 112 of the leadframe 110.

Referring to Figure 2C, the semiconductor power die 120 and the bond pad interconnect 150 are embedded in the laser-activatable mold compound 130 by a molding process. In the molding process, the leadframe 110 with the power semiconductor chip 120 mounted thereon may be placed in a molding cavity into which the liquid mold compound 130 is then introduced and cured.

The laser-activatable mold compound 130 may include an additive, e.g. in the form of an organic metal complex which is activated by a physio-chemical reaction induced by a focused laser beam. For example, the reaction cracks open the complex compounds in the mold compound and breaks off metal atoms from the organic ligands. The freed metal atoms act as nuclei for metal or metal alloy (e.g. Cu, Ni, NiP, Au, Cu/Ni/Au stack, etc.) coating/plating in regions of the mold compound 130 activated by a laser.

As apparent from Figure 2C, the laser-activatable mold compound 130 may completely cover the semiconductor power die 120, the bond pad interconnect 150, the upper surface 112A of the carrier section 112 and/or the upper surface 116A of the carrier interconnect section 116. A lower surface 112B of the carrier section 112 may remain exposed, for example.

There are several possibilities to expose the bond pad interconnect 150 (e.g., the second ends of the interconnect structures 152) and/or the upper surface 116A of the carrier interconnect section 116. In some examples the laser-activatable mold compound 130 may be thinned to expose the bond pad interconnect 150 and/or the upper surface 116A. For example, the laser-activatable mold compound 130 may be thinned by grinding until the bond pad interconnect 150 (e.g., the second ends of the interconnect structures 152) and/or the upper surface 116A is exposed.

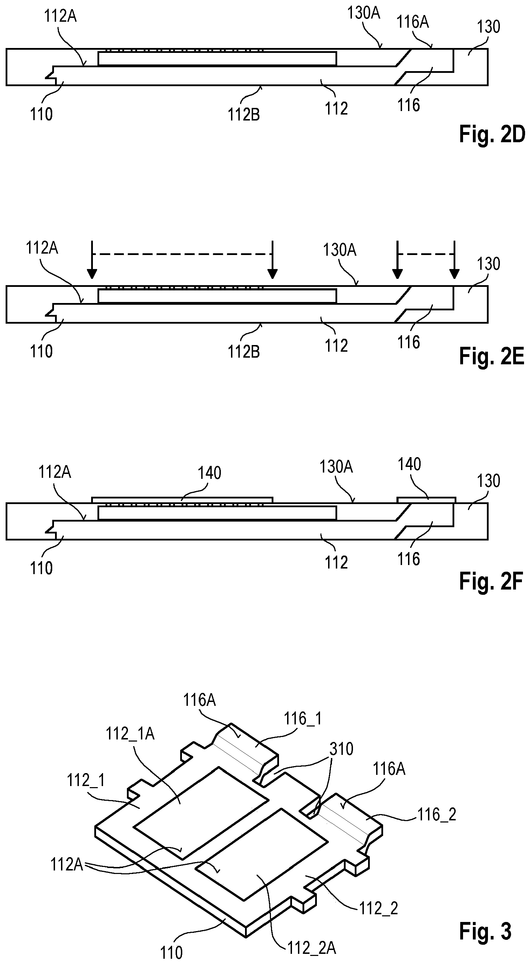

Figure 2D illustrates the structure of Figure 2C after thinning the laser-activatable mold compound 130.

In other examples, the bond pad interconnect 150 (e.g., the second ends of the interconnect structures 152) and/or at least parts of the upper surface 116A of the carrier interconnect section 116 may be exposed by drilling (e.g., by laser or mechanical drilling) of the laser-activatable mold compound 130. In this case, the bond pad interconnect 150 and/or the upper surface 116A of the carrier interconnect section 116 may only be slightly over-molded by, e.g., a thickness of about 5 - 20 um. In this case, the thinning process illustrated by Figure 2D may be skipped.

In other examples, the molding process may be carried out to provide an upper side 130A of the laser-activatable mold compound 130 at which the bond pad interconnect 150 (e.g., the second ends of the interconnect structures 152) and/or the upper surface 116A of the carrier interconnect section 116 are exposed. For example, an elastic element (e.g., rubber element) may be placed in the mold to prevent the laser-activatable mold compound 130 from fully encasing (over-molding) the bond pad interconnect 150 and/or the upper surface 116A of the carrier interconnect section 116. This way, thinning or drilling of the laser-activatable mold compound 130 to expose the bond pad interconnect 150 and/or the upper surface 116A of the carrier interconnect section 116 may be avoided. In this case, Figure 2C illustrating an over-mold process may be skipped and the molding process may directly arrive at the structure shown in Figure 2D, for example.

Referring to Figure 2E, a laser is directed at an upper side 130A of the laser-activatable mold compound 130 to laser-activate a plurality of regions 132 (see Figure 1) of the laser-activatable mold compound 130. The downward-facing arrows indicate a laser beam directed towards the laser-activatable mold compound 130 with exposed bond pad interconnect 150 and/or exposed upper surface 116A of the carrier interconnect section 116. By laser activation, metal atoms may be freed to act as nuclei for metal or metal alloy (e.g., Cu, Ni, NiP, Au, Cu/Ni/Au stack, etc.) at or in the laser-activated regions 132 of the laser-activatable mold compound 130.

Suitable polymers for such laser direct structuring of the laser-activatable mold compound 130 may include, but are not limited to, thermoset polymers having a resin base, ABS (acrylonitrile butadiene styrene), PC/ABS (polycarbonate / acrylonitrile butadiene styrene), PC (polycarbonate), PA/PPA (polyimide / polyphthalamide), PBT (polybutylene terephthalate), COP (cyclic olefin polymer), PPE (polyphenyl ether), LCP (liquid-crystal polymer), PEI (polyethylenimine or polyaziridine), PEEK (polyether ether ketone), PPS (polyphenylene sulfide), etc.

The term "laser-activated regions" 132 as used herein may mean regions of the laser-activatable mold compound 130 which have already been activated by a laser beam, as opposed to a laser-activatable region of the mold compound 130 which is capable of being activated by laser light but has yet to actually be activated. The process to form the laser-activated regions 132 may be referred to as "laser direct structuring" (LDS).

Referring to Figure 2F, an electrically conductive material is plated on the plurality of laser-activated regions 132 of the laser-activatable mold compound 130 to form the metal pads and/or metal traces 140. Hence, the metal pads and/or metal traces are structured directly on the mold compound 130 without having to use a sophisticated and expensive leadframe. Further, the molded power package 100 may be fabricated with a footprint of high design variability, as the footprint design (design of package terminals) can be chosen by laser illumination (e.g., LDS).

Accordingly, the distance between the active circuit and the package I/O (inputs/outputs) is controllable to minimize parasitic electric effects. Also, the metal pads and/or metal traces 140 which may be realized with this approach yield greater design freedom in that the die interconnect (including, e.g., wire stud bumps, metal pillars, vertical bond wires, etc. and, if a multiple layer laser-activatable mold compound is used, the layer metal structures formed on the respective layers) are not required to necessarily reside inside the footprint of a bond pad as is the case with a leadframe-type approach.

Figures 3 to 8B illustrate, by way of example, molded power packages 500, 700 containing two semiconductor power dies 120. Generally, molded power packages 100, 500, 700, as described herein, may contain one, two or more semiconductor power dies 120. Any disclosure below may also relate to a single semiconductor power die package 100 or to a multiple semiconductor power die package 500, 700. Further, any disclosure described above may relate to a molded power package 100 containing a single semiconductor power die 120, a molded power package 500, 700 containing two semiconductor power dies 120, or a molded power package containing more than two semiconductor power dies 120.

Referring to Figure 3, a leadframe 110 may include a first carrier section 112_1 and second carrier section 112_2, each having an upper surface 112A which may be at the same height. Further, the leadframe 110 may include a first carrier interconnect section 116_1 integral with the first carrier section 112_1 and a second carrier interconnect section 116_2 integral with the second carrier section 112_2. The upper surface 116A of the first carrier interconnect section 116_1 may be at the same height as the upper surface 116A of the second carrier interconnect section 116_2.

As illustrated in Figure 3, the first carrier interconnect section 116_1 and the second carrier interconnect section 116_2 may be separated from each other. More specifically, the upper surface 116A of the first carrier interconnect section 116_1 may be disconnected from the upper surface 116A of the second carrier interconnect section 116_2.

For example, the leadframe 110 may be provided with at least one recess 310 at the edge of the leadframe 110 at which the carrier interconnect sections 116_1, 116_2 are formed. For example, two recesses 310 may be formed at the edge of the leadframe 110 between the first and the second carrier interconnect sections 116_1, 116_2. The part of the leadframe 110 between the two recesses 310 may level with the (e.g., continuous) carrier sections 112_1, 112_2 of the leadframe 110.

In some examples the only parts of the leadframe 110 having an upper surface at a height that is elevated relative to the upper surface 112A of the carrier section(s) 112, 112_1, 112_2 of the leadframe 110, may be the carrier interconnect section(s) 116, 116_1, 116_2. The leadframe 110 may be produced by stamping-up or bending-up only the one or more carrier interconnect section(s) 116, 116_1, 116_2.

Figure 3 further shows a die pad zone 112_1A of first carrier section 112_1 and a die pad zone 112_2A of second carrier section 112_2. The die pad zones 112_1A, 112_2A may have been subjected to a surface treatment to provide a high quality surface for die bonding. For example, the die pad zones 112_1A, 112_2A may be selectively plated areas. As a specific example, the die pad zones 112_1A, 112_2A may be Ag plated areas for a glue bond die attach process.

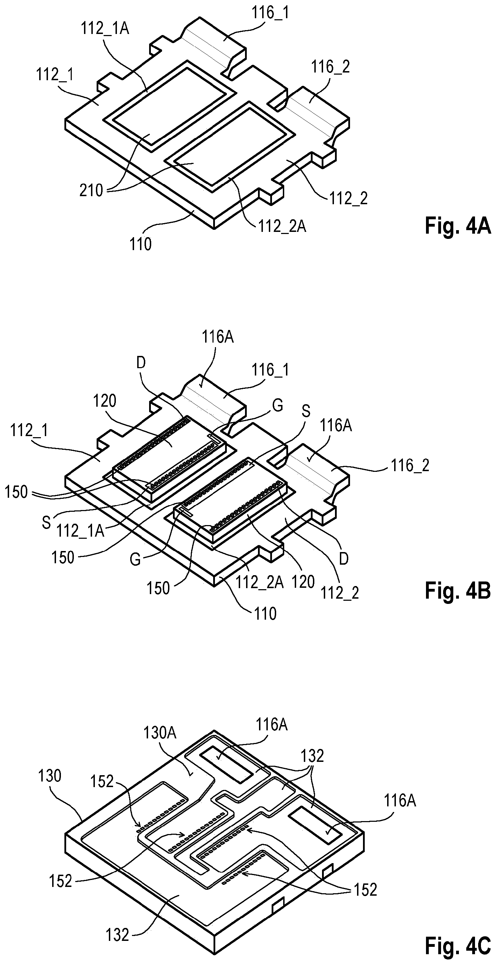

Referring to Figure 4A, a bonding material 210 is applied to the first carrier section 112_1 and the second carrier section 112_2. Reference is made to Figure 2A to avoid reiteration.

Referring to Figure 4B, semiconductor power dies 120 are placed on and bonded to the leadframe 110. Bond pads S (source), D (drain) and G (gate) may be provided at the upper sides of the semiconductor power dies 120. As shown in Figure 4B, the bond pad interconnect 150 formed by vertical interconnect structures 152 may already be provided on the bond pads S, D, G of the semiconductor power die 120. For example, the semiconductor power dies 120 are GaN transistors, e.g. GaN HEMTs. Reference is made to Figure 2B to avoid reiteration.

Figure 4C illustrates the structure of Figure 4B after over-molding (Figures 2C, 2D) and laser direct structuring (LDS, see Figure 2E) to form the laser-activated regions 132. As described above, the second ends of the vertical interconnect structures 152 and the upper surfaces 116A of the carrier interconnect sections 116_1, 116_2 may be exposed.

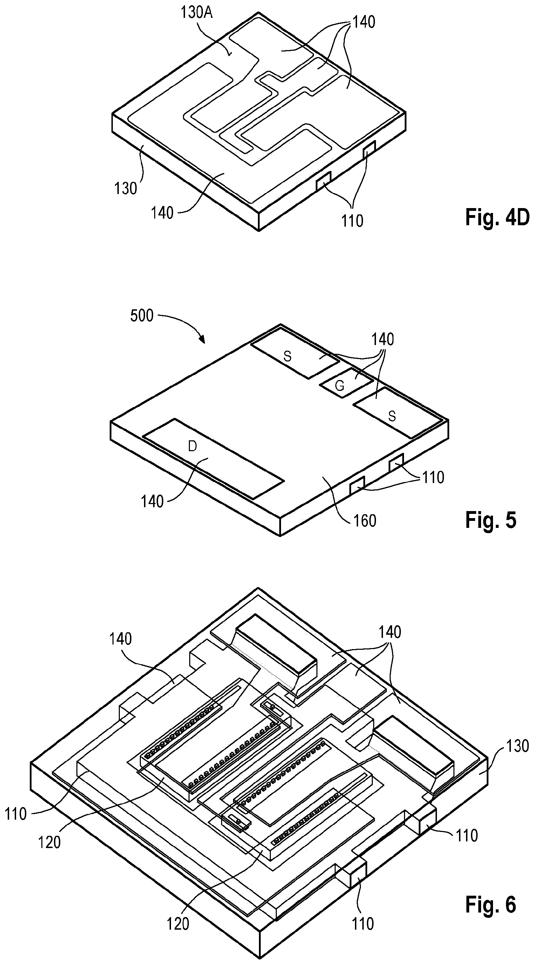

Figure 4D illustrates the structure of Figure 4C after plating the electrically conductive material on the laser-activated regions 132 to form the metal pads and/or metal traces 140. Reference is made to Figure 2F to avoid reiteration.

Referring to Figure 5, an isolation layer 160 may be applied over the metal pads and/or metal traces 140 and the (non-activated regions of) upper side 130A of the laser-activatable mold compound 130 (see also Figure 1). The isolation layer layer 160 may be structured to expose metal pads (e.g., S, D, G) of the metal pads and/or metal traces 140 of the molded power package 500. (Exposed) metal pads 140 may form external terminals of the molded power package 500. The metal pads 140 may be configured to be soldered to, e.g., an application board (not shown) on which the molded power package 500 is to be mounted. Further, as the carrier section 112 (or first and second carrier sections 112_1, 112_2) operating as a heat sink is typically on source (S) potential for the reasons set out above, it may be possible for an end user (depending on his choice) to use the (e.g., exposed) lower surface 112B of the carrier section 112 as a source (S) terminal of the molded power package 100.

Figure 6 illustrates a perspective semi-transparent view of the molded power package 500 of Figure 5 (the isolation layer 160 is not shown).

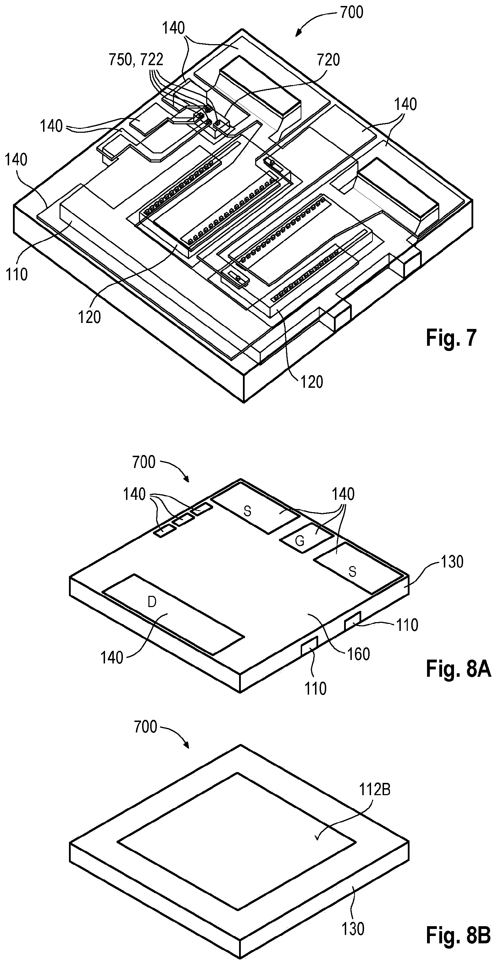

Referring to Figure 7, a molded power package 700 may include a gate driver die 720. The molded power package 700 may be similar to the molded power package 500 except that the gate driver die 720 is included and a gate driver die interconnect between the gate driver die 720 and the semiconductor power dies 120 is provided by the metal pads and/or metal traces 140, i.e. by LDS and metal plating. Further, the metal pads and/or metal traces 140 may provide for additional metal pads used as package terminals (Figure 8A). The gate driver die 720 may be embedded in the laser-activatable mold compound 130. The gate driver die 720 may have a plurality of gate driver bond pads 722.

The molded power package 700 may further comprise a gate driver bond pad interconnect 750. The gate driver bond pad interconnect 750 may electrically connect the plurality of gate driver bond pads 722 to the metal pads and/or metal traces 140 at the upper side 130A of the laser-activatable mold compound 130. The gate driver bond pad interconnect 750 may, e.g., be provided by vertical interconnect structures such as, e.g., wire stud bumps or metal pillars or vertical bond wires, i.e. by the same vertical interconnect structures 152 as used for the bond pad interconnect 150, for example.

Figure 8A is a perspective view on a top side of the power package 700. As apparent from Figure 8A, metal pads 140 connecting to the gate driver die 720 are exposed on the top side of the molded power package 700.

Figure 8B illustrates a bottom side of the power package 700. As mentioned before, the lower surface 112B of the carrier section 112 (including, e.g., the first and second carrier sections 112_1, 112_2) may be exposed at the bottom side of the package 700 (and, likewise, at the bottom side of other packages 100, 500, etc.).

In all examples, a multiple layer laser-activatable mold compound 130 may be used instead of the single layer mold compound 130 as exemplified above. When using a multiple layer laser-activatable mold compound, each layer of the multiple layer mold compound 130 is individually molded, laser-activated and plated during the process of manufacturing a multiple layer mold compound package. That way, the bond pad interconnect 150 may be generated mold compound layer-by-mold compound layer.

Further, one or more LDS processes and plating processes may be applied to a single layer or each layer of the laser-activatable mold compound 130.

While requiring multiple molding processes and/or multiple LDS and plating processes, a package realized with such multi-layer mold compound approach may yield still greater design freedom in terms of package I/O connectivity.

Further, a layer of an laser-activatable mold compound 130 (single layer or multi-layer) may be plated by a single LDS and single plating process (as exemplarily described above) or by a multi-LDS and multi-plating processes.

### EXAMPLES

The following examples pertain to further aspects of the disclosure:
Example 1 is a molded power package, comprising a laser-activatable mold compound having a plurality of laser-activated regions which are plated with an electrically conductive material to form metal pads and/or metal traces at a first side of the laser-activatable mold compound; a semiconductor power die embedded in the laser-activatable mold compound and having a plurality of bond pads; a bond pad interconnect electrically connecting the plurality of bond pads of the semiconductor power die to the metal pads and/or metal traces at the first side of the laser-activatable mold compound; a leadframe comprising a carrier section on which the semiconductor power die is mounted and a carrier interconnect section integral with the carrier section, the carrier interconnect section electrically connecting the carrier section to the metal pads and/or metal traces at the first side of the laser-activatable mold compound, wherein an upper surface of the carrier interconnect section is at a height that is elevated relative to an upper surface of the carrier section.
In Example 2, the subject matter of Example 1 can optionally include wherein the carrier interconnect section is an edge part of the leadframe.
In Example 3, the subject matter of Example 1 or 2 can optionally include wherein the bond pad interconnect comprises a plurality of wire stud bumps or metal pillars or vertical bond wires attached at a first end to the plurality of bond pads of the semiconductor power die and attached at a second end opposite the first end to the metal pads and/or metal traces at the first side of the laser-activatable mold compound.
In Example 4, the subject matter of Example 3 can optionally include wherein the second end of the plurality of wire stud bumps or metal pillars or vertical bond wires is at the height of the upper surface of the carrier interconnect section.
In Example 5, the subject matter of any of the preceding Examples can optionally include wherein the semiconductor power die is a horizontal semiconductor device having the plurality of bond pads only at an upper surface facing away from the carrier section of the leadframe.
In Example 6, the subject matter of any of the preceding Examples can optionally include wherein the semiconductor power die comprises a power transistor.
In Example 7, the subject matter of Example 6 can optionally include wherein the semiconductor power die comprises a GaN transistor, in particular a GaN high electron mobility transistor.
In Example 8, the subject matter of any of the preceding Examples can optionally further include a gate driver die embedded in the laser-activatable mold compound and having a plurality of gate driver bond pads; and a gate driver bond pad interconnect electrically connecting the plurality of gate driver bond pads to the metal pads and/or metal traces at the first side of the laser-activatable mold compound.
In Example 9, the subject matter of any of the preceding Examples can optionally further include a further semiconductor power die embedded in the laser-activatable mold compound and having a plurality of further bond pads; a further bond pad interconnect electrically connecting the plurality of further bond pads of the further semiconductor power die to the metal pads and/or metal traces at the first side of the laser-activatable mold compound; wherein the leadframe comprises a further carrier section on which the further semiconductor power die is mounted.
In Example 10, the subject matter of Example 9 can optionally further include a further carrier interconnect section integral with the further carrier section, the further carrier interconnect section electrically connecting the further carrier section to the metal pads and/or metal traces at the first side of the laser-activatable mold compound, wherein an upper surface of the further carrier interconnect section is at the same height as the upper surface of the carrier interconnect section.
In Example 11, the subject matter of any preceding Example can optionally include wherein the laser-activatable mold compound is a single layer mold compound.
In Example 12, the subject matter of any of Examples 1 to 10 can optionally include wherein the laser-activatable mold compound is a multiple layer mold compound.
Example 13 is a method comprising providing a leadframe comprising a carrier section and a carrier interconnect section integral with the carrier section, wherein an upper surface of the carrier interconnect section is at a height that is elevated relative to an upper surface of the carrier section; placing a semiconductor power die on the carrier section of a leadframe, the semiconductor power die having a plurality of bond pads facing away from the carrier section; attaching a bond pad interconnect to the plurality of bond pads of the semiconductor power die before or after placing the semiconductor power die on the carrier section; embedding the semiconductor power die and the bond pad interconnect in a laser-activatable mold compound; directing a laser at a first side of the laser-activatable mold compound to laser-activate a plurality of regions of the laser-activatable mold compound; and plating an electrically conductive material on the plurality of laser-activated regions of the laser-activatable mold compound to form metal pads and/or metal traces at the first side of the laser-activatable mold compound, wherein the bond pad interconnect electrically connects the plurality of bond pads of the semiconductor power die to the metal pads and/or metal traces at the first side of the laser-activatable mold compound, and the carrier interconnect section electrically connects the carrier section of the leadframe to the metal pads and/or metal traces at the first side of the laser-activatable mold compound.
In Example 14, the subject matter of Example 13 can optionally include wherein providing the leadframe comprises bending up or stamping up the carrier interconnect section relative to the carrier section of the leadframe.
In Example 15, the subject matter of Example 13 or 14 can optionally include wherein attaching the bond pad interconnect to the plurality of bond pads of the semiconductor power die comprises attaching a plurality of wire stud bumps or pillars or vertical bond wires to the plurality of bond pads of the semiconductor power die.
In Example 16, the subject matter of any of Examples 13 to 15 can optionally include wherein embedding the semiconductor power die and the bond pad interconnect in the laser-activatable mold compound comprises thinning the laser-activatable mold compound or drilling holes in the laser-activatable mold compound to expose the bond pad interconnect at the end facing away from the carrier section.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A molded power package, comprising:
a laser-activatable mold compound having a plurality of laser-activated regions which are plated with an electrically conductive material to form metal pads and/or metal traces at a first side of the laser-activatable mold compound;
a semiconductor power die embedded in the laser-activatable mold compound and having a plurality of bond pads;
a bond pad interconnect electrically connecting the plurality of bond pads of the semiconductor power die to the metal pads and/or metal traces at the first side of the laser-activatable mold compound;
a leadframe comprising a carrier section on which the semiconductor power die is mounted and a carrier interconnect section integral with the carrier section, the carrier interconnect section electrically connecting the carrier section to the metal pads and/or metal traces at the first side of the laser-activatable mold compound, wherein
an upper surface of the carrier interconnect section is at a height that is elevated relative to an upper surface of the carrier section.

2. The molded power package of claim 1, wherein the carrier interconnect section is an edge part of the leadframe.

3. The molded power package of claim 1 or 2, wherein the bond pad interconnect comprises a plurality of wire stud bumps or metal pillars or vertical bond wires attached at a first end to the plurality of bond pads of the semiconductor power die and attached at a second end opposite the first end to the metal pads and/or metal traces at the first side of the laser-activatable mold compound.

4. The molded power package of claim 3, wherein the second end of the plurality of wire stud bumps or metal pillars or vertical bond wires is at the height of the upper surface of the carrier interconnect section.

5. The molded power package of any of the preceding claims, wherein the semiconductor power die is a horizontal semiconductor device having the plurality of bond pads only at an upper surface facing away from the carrier section of the leadframe.

6. The molded power package of any of the preceding claims, wherein the semiconductor power die comprises a power transistor.

7. The molded power package of claim 6, wherein the semiconductor power die comprises a GaN transistor, in particular a GaN high electron mobility transistor.

8. The molded power package of any of the preceding claims, further comprising:
a gate driver die embedded in the laser-activatable mold compound and having a plurality of gate driver bond pads; and
a gate driver bond pad interconnect electrically connecting the plurality of gate driver bond pads to the metal pads and/or metal traces at the first side of the laser-activatable mold compound.

9. The molded power package of any of the preceding claims, further comprising:
a further semiconductor power die embedded in the laser-activatable mold compound and having a plurality of further bond pads;
a further bond pad interconnect electrically connecting the plurality of further bond pads of the further semiconductor power die to the metal pads and/or metal traces at the first side of the laser-activatable mold compound; wherein
the leadframe comprises a further carrier section on which the further semiconductor power die is mounted.

10. The molded package of claim 9, further comprising:
a further carrier interconnect section integral with the further carrier section, the further carrier interconnect section electrically connecting the further carrier section to the metal pads and/or metal traces at the first side of the laser-activatable mold compound, wherein
an upper surface of the further carrier interconnect section is at the same height as the upper surface of the carrier interconnect section.

11. The molded package of any of the preceding claims, wherein the laser-activatable mold compound is a single layer mold compound.

12. The molded package of any of claims 1 to 10, wherein the laser-activatable mold compound is a multiple layer mold compound.

13. A method of manufacturing a molded package, the method comprising:
providing a leadframe comprising a carrier section and a carrier interconnect section integral with the carrier section, wherein an upper surface of the carrier interconnect section is at a height that is elevated relative to an upper surface of the carrier section;
placing a semiconductor power die on the carrier section of a leadframe, the semiconductor power die having a plurality of bond pads facing away from the carrier section;
attaching a bond pad interconnect to the plurality of bond pads of the semiconductor power die before or after placing the semiconductor power die on the carrier section;
embedding the semiconductor power die and the bond pad interconnect in a laser-activatable mold compound;
directing a laser at a first side of the laser-activatable mold compound to laser-activate a plurality of regions of the laser-activatable mold compound; and
plating an electrically conductive material on the plurality of laser-activated regions of the laser-activatable mold compound to form metal pads and/or metal traces at the first side of the laser-activatable mold compound, wherein
the bond pad interconnect electrically connects the plurality of bond pads of the semiconductor power die to the metal pads and/or metal traces at the first side of the laser-activatable mold compound, and
the carrier interconnect section electrically connects the carrier section of the leadframe to the metal pads and/or metal traces at the first side of the laser-activatable mold compound.

14. The method of claim 13, wherein providing the leadframe comprises bending up or stamping up the carrier interconnect section relative to the carrier section of the leadframe.

15. The method of claim 13 or 14, wherein attaching the bond pad interconnect to the plurality of bond pads of the semiconductor power die comprises attaching a plurality of wire stud bumps or pillars or vertical bond wires to the plurality of bond pads of the semiconductor power die.

16. The method of any of claims 13 to 15, wherein embedding the semiconductor power die and the bond pad interconnect in the laser-activatable mold compound comprises thinning the laser-activatable mold compound or drilling holes in the laser-activatable mold compound to expose the bond pad interconnect at the end facing away from the carrier section.
